# EUROPÄISCHE PATENTSCHRIFT

(11) **EP 1 109 851 B1**
(45) Veröffentlichungstag und Bekanntmachung des Hinweises auf die Patenterteilung: **26.02.2003**
(21) Anmeldenummer: 99946094.2
(22) Anmeldetag: 02.09.1999
(51) Int. Cl.: C08G 73/08, C08G 75/32, H05B 33/14

(54) **AROMATISCHE POLY(1,3,4-HETERODIAZOLE) FÜR DEN EINSATZ IN OPTISCHEN VORRICHTUNGEN, INSBESONDERE ELEKTROLUMINESZENZBAUELEMENTEN**
AROMATIC POLY(1,3,4-HETERODIAZOLES) FOR USE IN OPTICAL DEVICES, ESPECIALLY ELECTROLUMINESCENT COMPONENTS
POLY(1,3,4-HETERODIAZOLES) AROMATIQUES S'UTILISANT DANS DES DISPOSITIFS OPTIQUES, NOTAMMENT DES COMPOSANTS ELECTROLUMINESCENTS

(30) Priorität: 03.09.1998 DE 19840195
(43) Veröffentlichungstag der Anmeldung: 27.06.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: JANIETZ, Silvia, D-14513 Teltow (DE); WEDEL, Armin, D-14513 Teltow (DE)
(86) Internationale Anmeldenummer: EP9906452
(87) Internationale Veröffentlichungsnummer: WO00014144

(56) Entgegenhaltungen:
- EP-A- 0 622 975
- DE-A- 2 750 202
- US-A- 3 385 837
- US-A- 4 476 295
- PATENT ABSTRACTS OF JAPAN vol. 1996, no. 12, 26. Dezember 1996 (1996-12-26) & JP 08 208745 A (CHISSO CORP), 13. August 1996 (1996-08-13)
- PATENT ABSTRACTS OF JAPAN vol. 1998, no. 01, 30. Januar 1998 (1998-01-30) & JP 09 255725 A (KEMIPURO KASEI KK), 30. September 1997 (1997-09-30)

## Beschreibung

Die vorliegende Erfindung betrifft Hauptkettenpolymere auf Basis von in organischen Lösungsmitteln löslichen aromatischen Poly(1,3,4-heterodiazolen), die sich für die Verwendung als Elektrolumineszenz- und/oder Elektronentransportschicht in optischen Devices, insbesondere für lichtemittierende Dioden (LEDs) eignen, sowie ein Verfahren zu ihrer Herstellung.

Die Nutzung von redoxaktiven Polymeren und organischen Monomerverbindungen in optischen Devices eröffnen die Möglichkeit durch einfache Verarbeitungstechniken großflächige Displays mit niedrigen Einsatzspannungen und einer Emission über den gesamten Spektralbereich zu realisieren, die mit den bisher herkömmlichen anorganischen Materialien nicht zu bewerkstelligen sind. Außerdem sind die Elektrolumineszenzdisplays im Gegensatz zu den Flüssigkristalldisplays selbstleuchtend und benötigen deshalb keine rückwärtige Beleuchtungsquelle.

Tang und van Slyke waren die ersten, die LEDs auf Basis von organischen Materialien vorstellten (C.W. Tang, S.A. van Slyke; *Appl. Phys. Lett.* **51** (1987) 913). Damit war es möglich, gegenüber den anorganischen Materialien die Lumineszenzausbeute zu erhöhen und LEDs herzustellen, die blaues Licht emittieren. Die organischen Multi- oder Einfachschichten bilden Sandwichstrukturen zwischen einer transparenten Indium-Zinnoxid-Anode (ITO) und einer Metallkathode mit kleiner Austrittsarbeit wie z.B. Mg, Al oder Ca. Mit dem Aufbau von Mehrfachschichtsystemen bestehend aus Elektronentransportschicht, Emitterschicht und Lochtransportschicht konnten die Lumineszenzausbeute und deren Stabilität erhöht werden (C. Adachi, T. Tsutsui, S. Saito; *App. Phys. Lett*. **57** (1990) 531; Y. Hamada, C. Adachi, T. Tsutsui, S. Saito; *Jpn. J. Appl. Phys*. **31** (1992) 1812). Bei der Verwendung von Monomeren werden die Schichten durch spezielle und damit kostenintensive Aufdampftechniken realisiert. Der Einsatz von Polymeren ermöglicht einen vereinfachten Device-Aufbau.

Konjugierte Polymere, die Halbleitereigenschaften mit Bandabständen zwischen 3,5 und 1,0 eV aufweisen, wie das genannte Poly(p-phenylen-vinylen) (PPV) oder Poly(p-phenylen) (PP), werden in dem Device-Aufbau von LEDs als Emitter und/oder Lochtransportschichten eingesetzt. Dabei ist es notwendig, organolösliche Materialien zu synthetisieren, um diese Polymere entsprechend durch einfach handhabbare Prozesse wie z.B. Spin-Coating- oder Dipping-Prozesse als Schichten aufzubringen. Ein Syntheseweg ist die Herstellung von löslichen Präpolymeren, die durch einen anschließenden Pyrolyseschritt im Vakuum in die entsprechenden unlöslichen konjugierten Polymere umgewandelt werden. Intensive Forschungsarbeiten zum PPV wurden unter anderem von Friend et al. (A.B. Holmes, D.D. Bradley, A.R. Brown, P.L. Burn, R.H. Friend; *Synthetic Metals* **55-57** (1993) 4031, J.H. Burroughes, D.D.C. Bradley, R.H. Friend, EP 0 423 283 B1) sowie von Hörhold et al. (M. Helbig, H.H. Hörhold; *Makromol. Chem*. **194** (1993) 1607; H.H. Hörhold et al. DE 195 05 416 A1) durchgeführt. Als besonders attraktiv erwiesen sich auch polymere und oligomere Thiophene. Sie gestatten die gezielte Einstellung der Wellenlänge des zu ermittierenden Lichts durch Variation der am Heterocyclus gebundenen Substituenten (M. Granström, M. Berggren und O. Inganäs; *Science* **267** (1995) 1479; E.G.J. Staring et al.; *Adv. Mater.* **6** (1994) 934), wobei jedoch die Quanteneffizienz unbefriedigend ist.

Der Aufbau von Multischichtsystemen auf Polymerbasis ermöglicht eine erhebliche Steigerung der Effizienz der emittierenden Dioden. Als solche zusätzlichen Schichten, die den Durchtritt der Elektronen durch die Schicht verbessern als auch eine Barriere für Löcher liefern, wurden bisher unter anderem Seitenkettenpolymere auf Polymethacrylatbasis mit 1,3,4-Oxadiazolgruppen in der Seitenkette (X.-C. Li, F. Cacialli, M. Giles, J. Grüner, R.H. Friend, A.B. Holmes, St.C. Moratti, T.M. Yong, *Adv. Mater.* **7**, 1995, 898) und Copolymere mit 1,3,4-Oxadiazoleinheiten in der Hauptkette eingesetzt (E. Buchwald, M. Meier, S. Karg, P. Pösch, H.-W. Schmidt, P. Strohriegel, W. Rieß, M. Schwoerer, *Adv. Mater*. **7**, 1995, 839, Q. Pei, Y. Yang, *Adv. Mater.* **7**, 1995, 559).

Eine Dünnschicht-Elektrolumineszenz-Device , die eine aus Polyoxadiazol-Derivaten bestehende Schicht umfasst, die sich zwischen Elektroden befindet und die über einen Vakuumabscheidungspolymerisationsprozess hergestellt wurde, ist in der EP-A-0 622 975 beschrieben. Trotz der enormen Fortschritte bei dem Einsatz von diesen Materialien in LEDs weisen die Bauteile noch Grenzen hinsichtlich Lebensdauer, Photostabilität und Stabilität gegen Wasser und Luft auf.

Aufgabe der vorliegenden Erfindung ist es, Polymere bereitzustellen, die zum einen ausgezeichnete Elektrolumineszenz- und/oder Elektronentransport-Eigenschaften besitzen, die andererseits aber auch im Vergleich zu den bisher bekannten Materialien eine erhebliche Verbesserung hinsichtlich des angestrebten Eigenschaftsprofils des gesamten Bauteils erwarten lassen, um diese in Beleuchtungs- oder Anzeigevorrichtungen zu verwenden.

Gegenstand der Erfindung sind in organischen Lösungsmitteln lösliche aromatische Poly(1,3,4-heterodiazole) umfassend aromatisches Poly(1,3,4-heterodiazol) umfassend 300 bis 1000 wiederkehrende Einheiten, ausgewählt aus der Gruppe bestehend aus 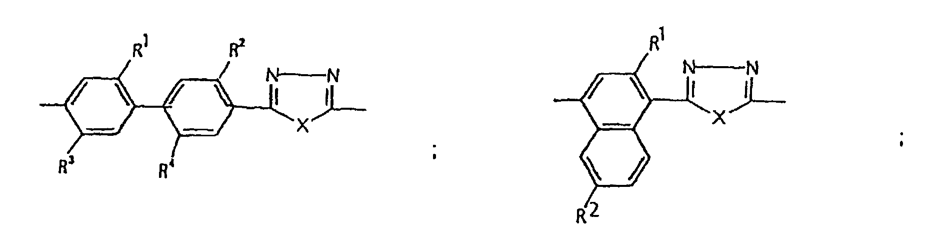 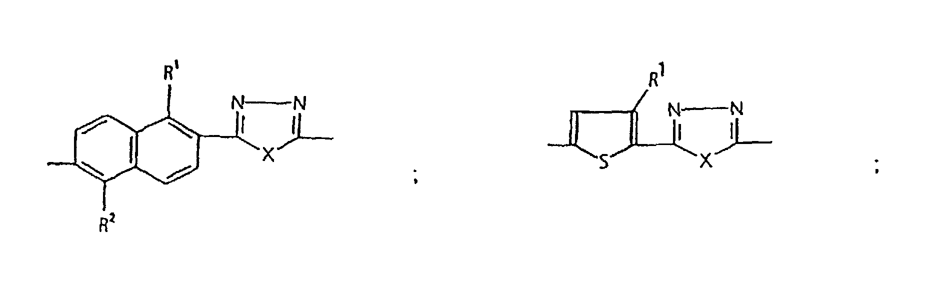 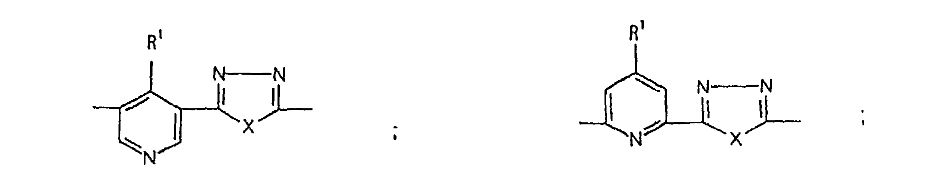 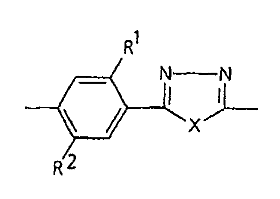 worin R¹, R², R³ und R⁴ gleich oder unterschiedlich sein können und jeweils für eine Alkyl-, Alkoxy-, Phenyl-, Phenoxy- oder Thiophenol-Gruppierung stehen und X für S, O oder N-Phenyl steht.

Eine bevorzugte Klasse der erfindungsgemäßen in organischen Lösungsmitteln löslichen aromatischen Poly(1,3,4-heterodiazole) weisen die allgemeine Formel 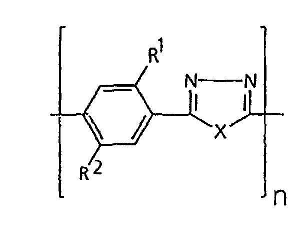 auf, worin R¹ und R² wie voranstehend definiert sind und n für eine ganze Zahl von 300 bis 1000 steht.

Wie bereits erwähnt, können die Substituenten R¹ bis R⁴ für Alkylgruppen stehen. Diese weisen im allgemeinen 1 bis 18, vorzugsweise bis zu 16 Kohlenstoffatome auf. Entsprechendes gilt für die vorgenannte Alkoxygruppe.

Die Alkyl- bzw. Alkoxygruppen können linear oder verzweigt sein und es ist bevorzugt, die Substituenten R¹ und R² und gegebenenfalls R³ und R⁴ so auszuwählen, daß einer dieser Reste verzweigt ist, während der andere bzw. die anderen Reste linear ist bzw. sind.

Die Substituenten R¹, R², R³ und R⁴ können auch für solche der vorgenannten Alkyl- bzw. Alkoxygruppierungen stehen, in denen ein oder mehrere nicht benachbarte CH₂-Gruppen durch -O- oder -S- ersetzt sind.

Weiterhin können R¹, R², R³ und R⁴ für eine Phenyl-, Phenoxy- oder Thiophenolgruppe stehen.

Die erfindungsgemäßen in organischen Lösungsmitteln löslichen aromatischen Poly(1,3,4-heterodiazole) werden durch ein Verfahren hergestellt, das dadurch gekennzeichnet ist, daß man äquimolare Mengen eines Säuredichlorids oder mehrerer Säuredichloride, ausgewählt aus der Gruppe bestehend aus 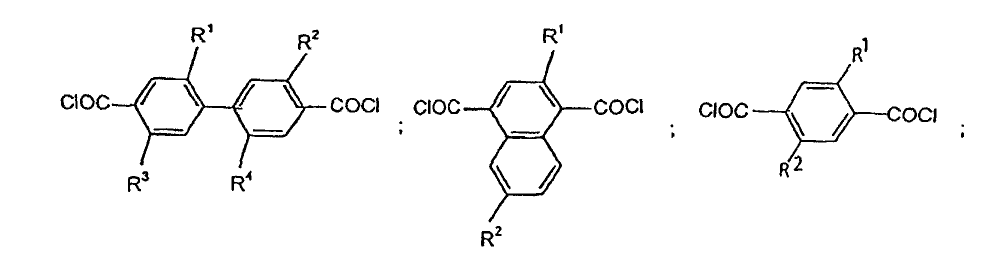 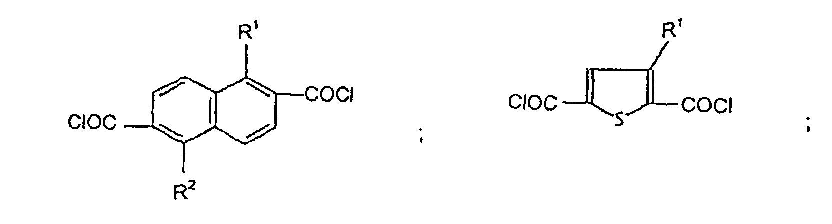 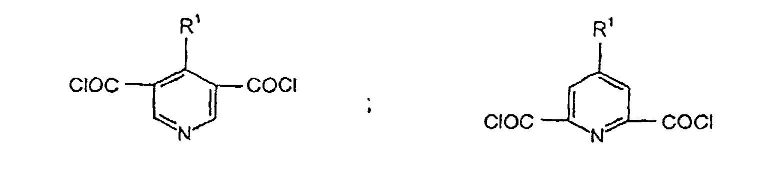 worin R¹, R², R³ und R⁴ wie in Anspruch 1 definiert sind, und eines Dicarbonsäurehydrazids oder mehrerer Dicarbonsäurehydrazide, ausgewählt aus der Gruppe bestehend aus 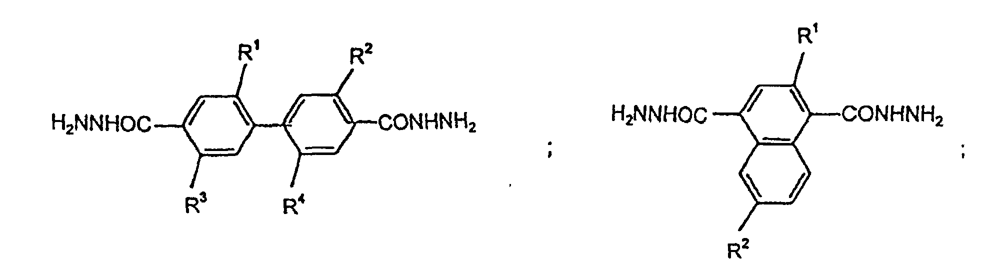 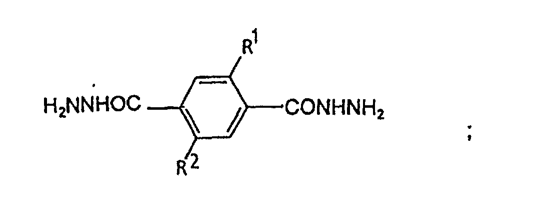 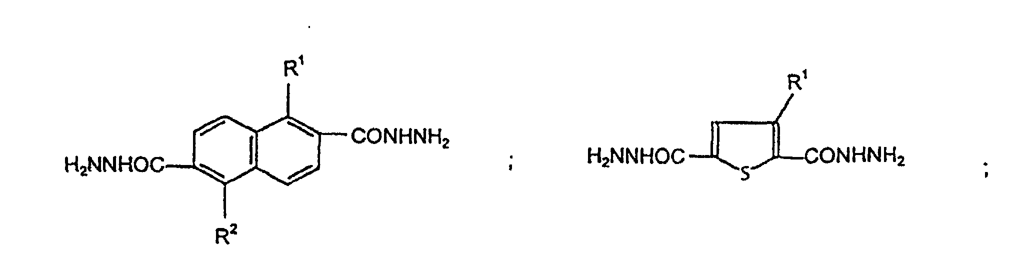 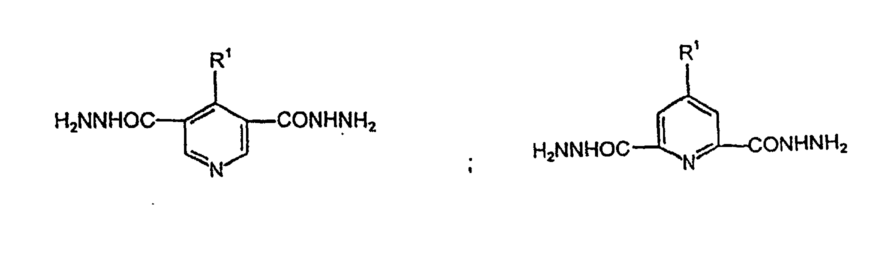 worin R¹, R², R³ und R⁴ wie in Anspruch 1 definiert sind, einer Kondensationspolymerisation unterwirft, das Kondensationsprodukt isoliert, reinigt und anschließend einer Ringachlußreaktion in Gegenwart eines Wasser entziehenden Mittels unterwirft und danach das Produkt isoliert und reinigt.

Dabei wird als Wasser entziehendes Mittel vorzugsweise Phosphoroxychlorid verwendet.

Soll anstelle des Sauerstoffs Schwefel oder N-Phenyl in den Heterodiazolring eingeführt werden, so wird bei der Ringschlußreaktion gleichzeitig Anilin (zur Einführung von N-Phenyl) oder Phosphorpentasulfid (zur Einführung von Schwefel) zugesetzt. Als Lösungsmittel werden vorzugsweise Benzol, Toluol, Xylol oder 1,2-Dichlorbenzol verwendet. Die Reaktionstemperatur beträgt vorzugsweise 80 bis 170°C und die Reaktionszeit 2 bis 20 Stunden. Die erhaltenen Polymere werden durch Fällen in einem Nichtlösungsmittel isoliert und können zur Reinigung, z.B. mit Alkoholen, extrahiert werden oder nochmals durch Lösen und Ausfällen in einem Nichtlösungsmittel gereinigt werden.

Wie bereits erwähnt, werden die entsprechenden Polyhydrazide durch Kondensation in Lösung hergestellt. Als Lösungsmittel wird hierbei vorzugsweise Benzol, Toluol, Xylol oder 1,2-Dichlorbenzol verwendet. Die Reaktionstemperatur beträgt vorzugsweise 80 bis 170°C und die Reaktionszeit 20 min bis 5 h.

Bei der Polykondensation wird das entsprechende Säuredichlorid bzw. eine Mischung von Säuredichloriden unter Erwärmen in dem vorgenannten Lösungsmittel oder einem Gemisch daraus gelöst und die äquimolare Menge eines oder mehrerer der vorgenannten Säuredihydrazide in Lösung zugetropft.

Die Kondensation erfolgt zweckmäßigerweise durch Zugabe eines basischen Katalysators, vorzugsweise von Pyridin.

Die Umsetzungen erfolgen nahezu quantitativ. Die erhaltenen Kondensationsprodukte werden durch Ausfällen, z.B. in Alkoholen, isoliert und anschließend durch Extraktion mit Alkoholen gereinigt.

Die Herstellung der Ausgangsverbindungen erfolgt nach an sich literaturbekannten Methoden, wie sie z.B. in Standardwerken zur Organischen Synthese, z.B. Houben-Weyl, Methoden der Organischen Chemie, Georg Thieme Verlag, Stuttgart, oder entsprechenden einschlägigen Journalen beschrieben werden.

Für die Synthese des thianthrenhaltigen 1,3,4-oxadiazolhaltigen Polymers beispielsweise ist als Ausgangsmaterial die 3-Phenoxythiophen-2,5-dicarbonsäure erforderlich, deren Herstellung in *J. Org. Chem.* **1982**, *47*, 1755-1759 (J.W.H. Watthey, M. Desai) beschrieben ist.

Die erfindungsgemäßen Polymere weisen im allgemeinen 300 bis 1000, vorzugsweise 300 bis 800, besonders bevorzugt 300 bis 700, Wiederholungseinheiten auf.

Die erfindungsgemäßen Polymere zeichnen sich unter anderem durch hohe Stabilität bei einer hohen Fluoreszenzquantenausbeute aus, wobei diese Polymere Licht im blauen Bereich emittieren. Außerdem stellen sie aufgrund des 1,3,4-Heterodiazol-Ringes als Elektronenakzeptor Materialien mit sehr guten Barriereeigenschaften gegenüber Löchern dar. Die LUMO-Energien der bereitgestellten Polymere passen sich sehr gut an die Austrittsarbeiten der Kathodenmaterialien an, was durch cyclovoltammetrische Messungen ermittelt wurde. Diese Tatsache ermöglicht den effizienten Aufbau von Mehrschichtanordnungen.

Die Erfindung beruht dabei auf der überraschenden Feststellung, daß die Einstellung der Elektrolumineszenz über die Variation der Schichtdicke möglich ist. Zunächst wurde vermutet, daß sich durch das Aufbringen der aromatischen Poly(1,3,4-heterodiazole) nur die Einsatzspannung des Devices verringert. Völlig überraschend verändert sich jedoch auch die Lage der Rekombinationszone in einem Multischichtsystem in dieser Art, daß sich die Elektrolumineszenz gezielt durch die erfindungsgemäßen polymeren Schichten durch Wahl der Schichtdicken einstellen läßt.

Die erfindungsgemäßen heterodiazolhaltigen Hauptkettenpolymere lassen sich u.a. in Form von Schichten und Filmen in normal gängigen Lösungsmitteln präparieren und können deshalb als Elektrolumineszenz- und/oder Elektronentransportschichten in optischen Devices verwendet werden. Die Löslichkeit in organischen Lösungsmitteln solcher steifkettiger, vollaromatischer Poly(1,3,4-heterodiazole) wurde durch das Einführen von Alkyl-, Alkoxy- Thiophenol- bzw. Phenoxy-Seitengruppen in die polymere Hauptkette erreicht.

Für ihre Verwendung als Elektrolumineszenz- und/oder Elektronentransportschichten in optischen Vorrichtungen werden die synthetisierten Polymere durch Spin-Coating- oder Cast-On-Techniken auf verschiedenen festen Substraten (ITO auf Glassubstraten) und auf flexiblen leitfähigen Polyethylenterephtalatfolien aufgebracht. Die Polymerschichtdicken liegen zwischen 40 und 500 nm (je nach Schichtsystem) und müssen je nach dem Aufbau der optischen Vorrichtung optimiert werden. Bei der Realisierung von Mehrfachschichtsystemen wird zunächst auf die löcherinjizierende Elektrode eine Lochtransportschicht und anschließend darauf die Elektronentransportschicht, bestehend aus den erfindungsgemäßen Polymeren, präpariert. Danach erfolgt die Aufbringung einer elektroneninjizierenden Elektrode, z.B. Ca, Mg, Al, In, Mg/Ag. Die eingesetzten Polymermaterialien müssen so aufeinander abgestimmt werden, daß z.B. ein gegenseitiges Anlösen verhindert wird. Die Erzeugung von injizierenden Kontakten erfolgt mittels spezieller Mehrtiegelwiderstandsverdampfung und DC- bzw.

RF-Sputterquellen. Als löcherinjizierende Elektrode eignen sich unter anderem Materialien, die eine hohe Austrittsarbeit (>4,5 eV) besitzen. Dazu zählen unter anderem Gold, Platin und Indium-Zinn-Oxid (ITO)-Schichten. Die ITO-Schichten (auch kommerziell erhältlich: Balzers) müssen durch spezielle Aufdampfverfahren (RF-Sputtern) so ausgeführt werden, daß sie sowohl eine hohe Transparenz (>80%) als auch einen kleinen Oberflächenwiderstand (<KΩ/cm²) besitzen. Die typischen Schichtdicken müssen deshalb zwischen 80 und 150 nm liegen. Im Betrieb werden Elektronen von der Kathode in die Elektronentransportschicht bzw. in die lichtemittierende Schicht injiziert. Gleichzeitig werden Löcher von der Anode in die Lochtransportschicht bzw. direkt in die lichtemittierende Schicht injiziert. Unter dem Einfluß der angelegten Spannung bewegen sich die Ladungsträger durch die aktiven Schichten aufeinander zu. An den Grenzflächen zwischen den Ladungstransportschichten und der lichtemittierenden Schicht bzw. direkt in der lichtemittierenden Schicht kommt es zur Bildung von Elektronen/Loch-Paaren, die unter Aussendung von Licht rekombinieren. Die Farbe der Lichtemission kann z.B. durch Variation von Schichtdicken in einem Mehrfachschichtsystem variiert werden. Nach der Kontaktierung der Elektroden erfolgt die Messung der Strom-Spannungskennlinien und die Bestimmung der optischen Eigenschaften (Absorption, Photolumineszenz, Elektrolumineszenz).

Die Erfindung wird durch die nachstehenden Ausführungsbeispiele näher erläutert, ohne sie dadurch beschränken zu wollen.

### Ausführungsbeispiele

### Synthesen der Ausgangstoffe zur Herstellung von Poly(2,5-di-phenyl{2',5'-di(2-ethylhexyloxy)}-1,3,4-oxadiazol)

### 2,5-(2-Ethylhexyloxy)diethylterephthalat

2,5-Dihydroxydiethylterephthalat (10 g; 0,04 mol) und 2-Ethylhexyliodid (192 g; 0,8 mol) werden in 250 ml abs. Cyclohexanon gelöst. Nach der Zugabe von fein gepulvertem K₂CO₃ (80 g; 0,58 mol) und KJ (1,35 g; 8 mmol) wird 5 h unter Rückfluß und Stickstoff gekocht. Anschließend wird die Lösung möglichst heiß vom Kaliumcarbonat abfiltriert und der Rückstand zweimal mit Cyclohexanon gewaschen. Das Lösungsmittel wird abdestilliert und das nicht umgesetzte 2-Ethylhexyliodid destillativ entfernt. Zurück bleibt ein hellbraunes Öl.
Ausbeute: 14,5 g = 76%

| | | | | |
|---|---|---|---|---|
| EA | C₂₈H₄₆O₆ (478,7 g/mol) | | | |
| | ber. | C 70,25% | H 9,69% | O 20,05% |
| | gef. | C 69,75% | H 9,68% | |

### 2,5-(2-Ethylhexyloxy)terephthalsäuredihydrazid

Das 2,5-(2-Ethylhexyloxy)diethylterephthalat (5,5 g; 0,0115 mol) und 10 ml Hydrazinhydrat (0,2 mol) werden in 50 ml Ethanol gelöst und ca. 6 h zum Rückfluß erhitzt. Nach Abkühlung der Reaktionslösung wird das ausgefallene Produkt abgesaugt und getrocknet. Anschließend wird das Produkt aus Ethanol umkristallisiert.
Ausbeute: 3,21 g = 61% Smp.: 68°C

| | | | | |
|---|---|---|---|---|
| EA | C₂₄H₄₂N₂O₄ (450,6 g/mol) | | | |
| | ber.: | C 63,97% | H 9,39% | N 12,43% |
| | gef.: | C 64,0% | H 9,42% | N 12.34% |

### 2,5-(2-Ethylhexyloxy)terephthalsäure

Das 2,5-(2-Ethylhexyloxy)diethylterephthalat (5,5 g; 0,0115 mol) wird in einer Lösung aus KOH (24 g; 0,43 mol) in Wasser (100 ml) und Ethanol (40 ml) 4 h unter Rückfluß gekocht. Beim Ansäuern des erkalteten Reaktionsgemisches mit konzentrierter HCl fällt die Dicarbonsäure aus. Diese wird abgetrennt und getrocknet. Anschließend wird diese aus einem Gemisch von Wasser/Ethanol (3:5) umkristallisiert.
Ausbeute: 3,15 g = 65% Smp.: 134 bis 136°C

| | | | |
|---|---|---|---|
| EA | C₂₄H₃₈O₆ (422,5 g/mol) | | |
| | ber. | C 68,22% | H 9,06% |
| | gef. | C 68,416% | H 9,30% |

### 2,5-(2-Ethylhexyloxy)terephthalsäuredichlorid

Die 2,5-(2-Ethylhexyloxy)terephthalsäure (3,15 g; 0,0075 mol), 25 ml Thionylchlorid und 2 Tropfen DMF werden 2 Tage bei Raumtemperatur gerührt. Das überschüssige Thionylchlorid abdestilliert und der ölige Rückstand im Ölpumpenvakuum getrocknet.
Ausbeute: 3,39 g = 99%

| | | | |
|---|---|---|---|
| EA | C₂₄H₃₆O₂Cl₂ (302,5 g/mol) | | |
| | ber. | C 70,26% | H 9,68% |
| | gef. | C 71,03% | H 10,23% |

### Poly(di-phenyl{2,5-di(2-ethylhexyloxy)}-hydrazid)

Das 2,5-(2-Ethylhexyloxy)terephthalsäuredihydrazid (1,78 g; 3,96 mmol) wird in 20 ml abs. Dichlorbenzol gelöst und mit 1 ml Pyridin versetzt. Die Lösung wird unter Rühren auf 130°C erhitzt. Das 2,5-(2-Ethylhexyloxy)terephthalsäuredichlorid (1,82 g; 3,96 mmol) wird in 10 ml Dichlorbenzol gelöst und bei 130°C langsam zugetropft, dabei beobachtet man eine Zunahme der Viskosität der Lösung. Anschließend wird die Kondensatlösung 1 h bei 160°C gerührt. Die noch heiße Kondensatlösung wird in ca. 600 ml Methanol langsam ausgefällt, mehrmals mit Methanol gewaschen und anschließend mit einer Soxhletapparatur ca. 20 h extrahiert. Es entstand ein hellgelb gefärbtes fasriges Polymer.
Ausbeute: 3,13 g = 94%

| | | | | | |
|---|---|---|---|---|---|
| EA | C₂₄H₃₈N₂O₄ (419,0 g/mol) | | | | |
| | ber. | C 68,73% | H 9,07% | N 6,68% | O 15,27% |
| | gef. | C 67,23% | H 9,35% | N 6,41% | O 15,30% |

### Poly(2,5-di-phenyl{2',5'-di(2-ethylhexyloxy)}-1,3,4-oxadiazol)PODH2

### Polymersynthese

In 70 ml o-Dichlorbenzol und 3 ml Phosphoroxychlorid werden 2 g Poly(di-phenyl{2,5-di(2-ethylhexyloxy)}-hydrazid) suspendiert. Danach wird die Reaktionslösung zum Sieden erhitzt, wobei das Polyhydrazid in Lösung geht. Die Reaktionslösung wird noch 3 h dabei belassen. Anschließend wird die heiße Reaktionslösung .in 800 ml Methanol ausgefällt und mehrmals mit Methanol gewaschen. Das entstandene leuchtend gelbe und stark blau fluoreszierende Polyoxadiazol wurde durch eine 22stündige Soxhletextraktion gereinigt.
Ausbeute: 1,75 g = 92%

| | | | | | |
|---|---|---|---|---|---|
| EA | C₂₄H₃₆N₂O₃ (401,0 g/mol) | | | | |
| | ber. | C 71,82% | H 8,98% | N 6,98% | O 11,97% |
| | gef. | C 70,28% | H 9,00% | N 7,01% | O 12,55% |

¹³C-NMR (CDCl₃) δ = 10,9 (CH₃); 13,9 (CH₃); 30,3, 29,01, 23,7, 22,9 (CH₂); 39,4 (CH); 72,2 (CH₂O); 114,7, 116,8, 151,4 (aromat. C); 163,3 ppm (Oxadiazol C)
M_{W}: 2,54 x 10⁵ g/mol (GPC, Lichtstreuung)

### Deviceherstellung

Zur Herstellung einer Elektrolumineszenzanordnung wurde das PODH2 in einem organischen Lösungsmittel (Toluol) gelöst und in einer Zweischichtanordung als Elektronentransport- und Emittermaterial eingesetzt.

Auf einem mit einer ITO-präparierten Glassubstrat (Balzers) von ca. 25 cm² wird nacheinander zunächst eine lochleitende Schicht, z.B. Polyphenylenvinylen (PPV), mit einer Dicke von 110 nm aufgebracht. Danach erfolgt die Aufbringung einer PODH2-Schicht mit Hilfe eines Spin-Coating-Prozesses. Die Aluminiumelektrode wurde strukturiert und hat einen Durchmesser von 5 mm.

Nach Kontaktierung der Elektroden (ITO und Aluminium) und dem Anlegen einer negativen Spannung an die Aluminiumelektrode zeigen sich in Abhängigkeit von den Schichtdicken der PODH2-Schichten unterschiedliche Elektrolumineszenz (EL)-Spektren. Die Schichtdicken wurden durch 3 unterschiedliche Konzentrationen (Gew.-Prozent) einer PODH2-Lösung bei gleichem Spin-Coating-Parameter (1400 min⁻¹) realisiert. Alle so präparierten Substrate wurden dann anschließend bei 80°C 2 h im Vakuumschrank getempert. Eine Device-Anordnung mit einer PODH2-Schicht, hergestellt aus einer 0,25%igen Lösung zeigt bei ca. 8 V eine grüne Emission. Ein Device, welches mit einer 0,5%igen PODH2-Lösung hergestellt wurde, zeigt bei etwa 10 V eine blaugrüne Emission. Schließlich zeigt ein Device, welches mit einer 1,0%igen Lösung hergestellt wurde, bei 12 V eine blaue Emission (siehe Tabelle).

| | Schichtdicke/nm | EL Emission/nm |
|---|---|---|
| PODH2 0,25% | 20 | 525 |
| PODH2 0,50% | 35 | 495 |
| PODH2 1,00% | 55 | 480 |

Die Abhängigkeit der EL von der Schichtdicke der Elektronen- bzw. Emitterschicht liegt in der räumlichen Tiefe der Rekombinationszone der Landungsträger begründet und kann so gezielt eingestellt werden.

### Poly(2,5-di-phenyl{2',5'-di(2-ethylhexyloxy)}-1,3-phenyl-4-triazol)POT

### Polymersynthese

In 35 ml Dichlorbenzol werden bei 0°C 1,4 g Anilin (0,015 mol) und 0,23 ml POCl₃ unter Rühren und Stickstoffatmosphäre gelöst. Danach wird die Kühlung entfernt und die Reaktionslösung noch 1,5 h bei Raumtemperatur gerührt. Es wird 1 g des Poly(di-phenyl{2,5-di(2-ethylhexyloxy)}hydrazids) in einer Lösung suspendiert und zum Rückfluß für 24 h erwärmt. Danach wurde das Polymer in Methanol/Wasser ausgefällt (10:1) und abgesaugt. Das anfallende Polymer wurde mehrmals mit 5% NaOH behandelt und anschließend mit Wasser und Methanol gewaschen.
Ausbeute: 0,75 g = 63%

| | | | | | |
|---|---|---|---|---|---|
| EA | C₃₀H₄₁N₃O₂ (475,0 g/mol) | | | | |
| | ber. | C 75,79% | H 8,63% | N 8,84% | O 6,74% |
| | gef. | C 73,28% | H 9,20% | N 8,21% | O 8,85% |

M_{W}: 1,81 x 10⁵ g/mol (GPC, Lichtstreuung)

### Deviceherstellung

Auf einem mit einer ITO-präpariertem Glassubstrat (Balzers) von ca. 25 cm² wurde zunächst eine Polyphenylenvinylen (PPV)-Schicht mit einer Dicke von 110 nm aufgebracht. Zur Herstellung einer Doppelschichtanordnung wurde dann eine Lösung mit Toluol und POT hergestellt (1,0 Gew.-%), die anschließend auf der PPV-Schicht mit Hilfe eines Spin-Coating-Prozesses (1400 min⁻¹) aufgetragen wurde und bei 80°C 2 h im Vakuumschrank getempert wurde. Die POT-Schichtdicke wurde mit 60 nm bestimmt. Die Aluminiumelektrode wurde strukturiert und hat einen Durchmesser von 5 mm. Nach Kontaktierung der Elektroden (ITO und Aluminium) und dem Anlegen einer negativen Spannung von ca. 12 V an die Aluminiumelektrode wurde eine blaue Elektrolumineszenz bei ca. 480 nm beobachtet.

### Poly(2,5-di-phenyl{2',5'-di(2-ethylhexyloxy)}-1,3,4-thiadiazol)PTDH

In 35 ml o-Dichlorbenzol und 3 ml Phosphoroxychlorid werden 1 g Poly(di-phenyl{2,5-di(2-ethylhexyloxy)}-hydrazid) (2,39 mmol) und 1 g P₂S₅ (4,5 mmol) suspendiert. Danach wird die Reaktionslösung zum Sieden erhitzt, wobei das Polyhydrazid in Lösung geht. Die Reaktionslösung wird noch 12 h dabei belassen. Anschließend wird die heiße Reaktionslösung in 800 ml Methanol ausgefällt und mehrmals mit Methanol gewaschen. Das entstandene, leuchtend gelbe Polythiadiazol wurde durch eine 22stündige Soxhletextraktion gereinigt.
Ausbeute: 0,82 g = 63%

| | | | | | |
|---|---|---|---|---|---|
| EA | C₂₄H₃₆N₂O₂S (417,0 g/mol) | | | | |
| ber. | C 69,06% | H 8,63% | N 6,71% | O 7,67% | S 7,76% |
| gef. | C 67,51% | H 9,20% | N 7,21% | O 9,03% | S 7,04% |

M_{W}: 1,41 x 10⁵ g/mol (GPC, Lichtstreuung)

### Deviceherstellung

Auf einem mit einer ITO-präpariertem Glassubstrat (Balzers) von ca. 25 cm² wurde zunächst eine Polyphenylenvinylen (PPV)-Schicht mit einer Dicke von 80 nm aufgebracht. Zur Herstellung einer Doppelschichtanordnung wurde dann eine Lösung mit Toluol und PTDH hergestellt (0,5 Gew.-%), die anschließend auf der PPV-Schicht mit Hilfe eines Spin-Coating-Prozesses (1400 min⁻¹) aufgetragen wurde und bei 80°C 2 h im Vakuumschrank getempert wurde. Die PTDH-Schichtdicke wurde mit 80 nm bestimmt. Die Aluminiumelektrode wurde strukturiert und hat einen Durchmesser von 5 mm. Nach Kontaktierung der Elektroden (ITO und Aluminium) und dem Anlegen einer negativen Spannung von ca. 8 V an die Aluminiumelektrode wurde eine grüne Elektrolumineszenz bei ca. 520 nm beobachtet.

## Patentansprüche

1. Aromatisches, in organischen Lösungsmitteln lösliches Poly(1,3,4-heterodiazol) umfassend 300 bis 1000 wiederkehrende Einheiten, ausgewählt aus der Gruppe bestehend aus 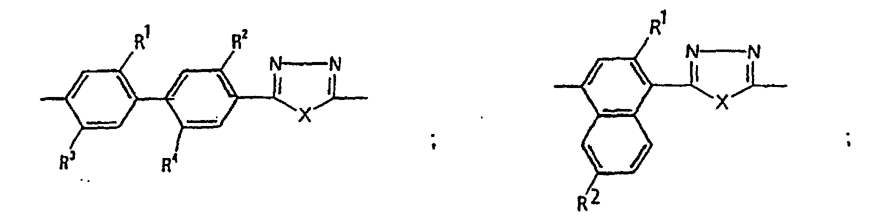 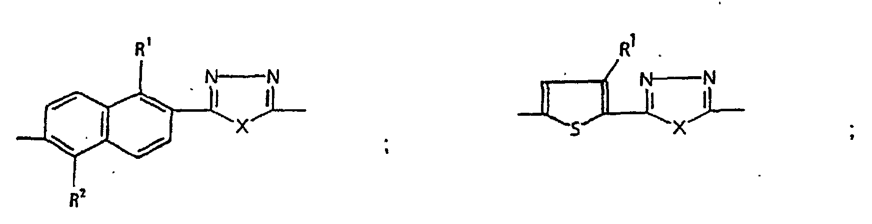 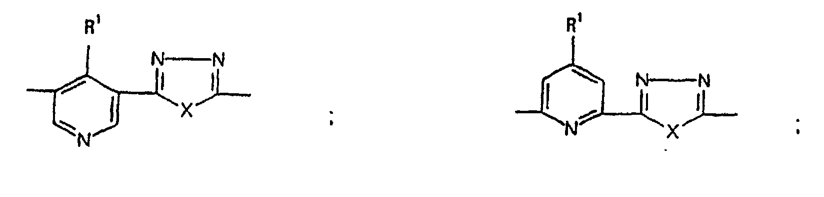 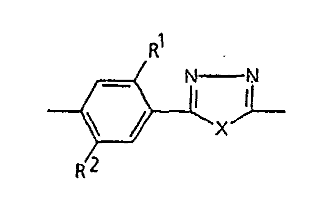 worin R¹, R², R³ und R⁴ gleich oder unterschiedlich sein können und jeweils für eine Alkyl-, Alkoxy-, Phenyl-, Phenoxy- oder Thiophenol-Gruppierung stehen und X für S, O oder N-Phenyl steht.

2. Aromatisches Poly(1,3,4-heterodiazol) nach Anspruch 1 der allgemeinen Formel 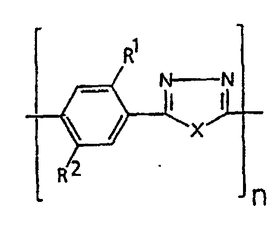 worin R¹, R², R³, R⁴ und X wie in Anspruch 1 definiert sind und n für eine ganze Zahl von 300 bis 1000 steht.

3. Aromatisches Poly(1,3,4-beterodiazol) nach Anspruch 1 oder 2, **dadurch gekennzeichnet, daß** R¹ und/oder R² für eine Alkyl-Gruppierung stehen, in der ein oder mehrere nicht benachbarte CH₂-Gruppen durch -O- oder -S- ersetzt sind.

4. Aromatisches Poly(1,3,4-heterodiazol) nach den Ansprüchen 1 bis 3, **dadurch gekennzeichnet, daß** es 300 bis 700 wiederkehrende Einheiten umfaßt.

5. Aromatisches Poly(1,3,4-heterodiazol) nach Anspruch 1, **dadurch gekennzeichnet, daß** es Poly(2,5-di-phenyl{2',5'-di(2-ethyl-hexyloxy)}-1,3,4-oxadiazol), Poly(2,5-di-phenyl{2',5'-di(2-ethyl-hexyloxy)}-1,3-phenyl-4-triazol) oder Poly(2,5-di-phenyl{2',5'-di(2-ethyl-hexyloxy)}-1,3,4-thiadiazol) ist.

6. Verfahren zur Herstellung eines aromatischen Poly(1,3,4-heterodiazols) nach Anspruch 1, **dadurch gekennzeichnet, daß** man äguimolare Mengen eines Säuredichlorids oder mehrerer Säuredichloride, ausgewählt aus der Gruppe bestehend aus 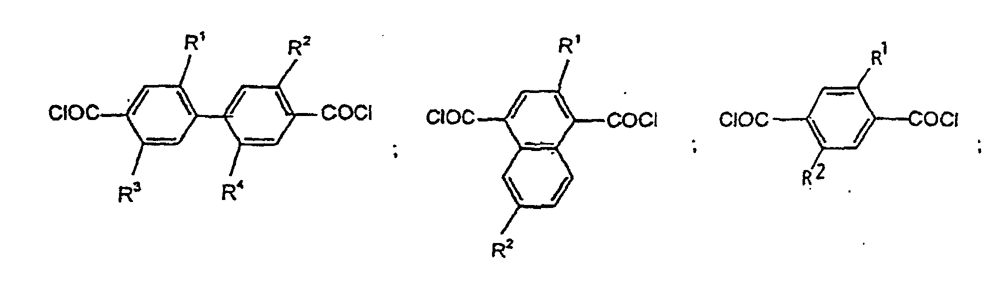 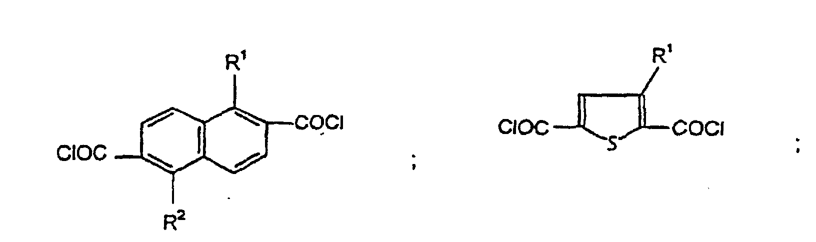 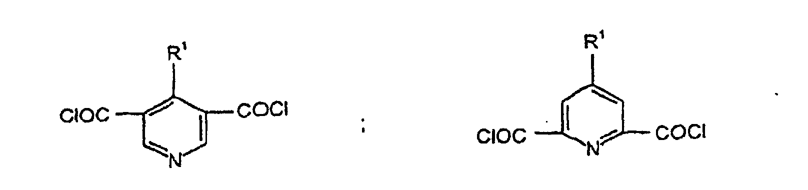 worin R¹, R², R³ und R⁴ wie in Anspruch 1 definiert sind, und eines Dicarbonsäurehydrazids oder mehrerer Dicarbonsäurehydrazide, ausgewählt aus der Gruppe bestehend aus 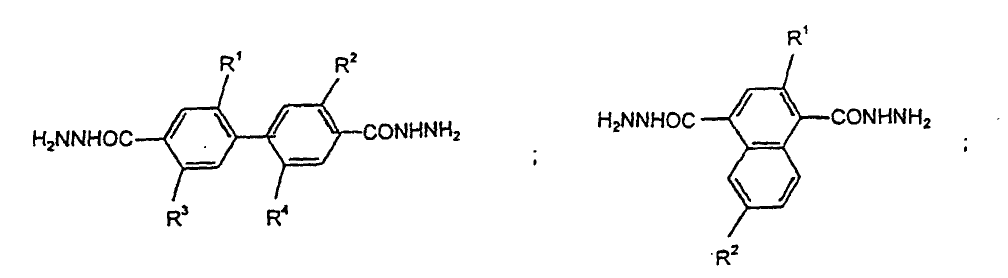 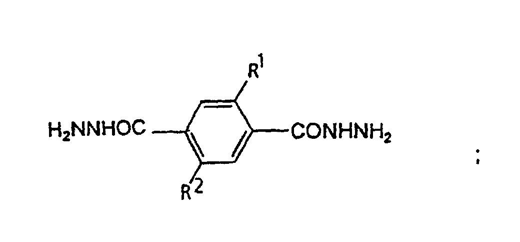 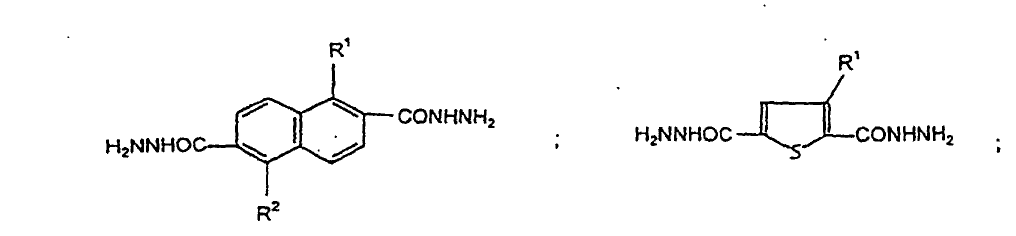 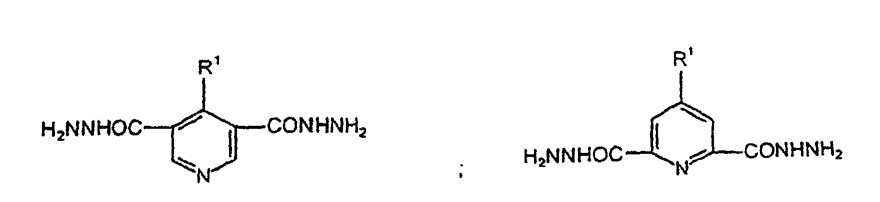 worin R¹, R², R³ und R⁴ wie in Anspruch 1 definiert sind, einer Kondensationspolymerisation unterwirft, das Kondensationsprodukt isoliert, reinigt und anschließend einer Ringschlußreaktion in Gegenwart eines Wasser entziehenden Mittels unterwirft und danach das Produkt isoliert und reinigt.

7. Verfahren nach Anspruch 6, **dadurch gekennzeichnet, daß** die Kondensationspolymerisation in Gegenwart eines basischen Katalysators durchgeführt wird.

8. Verfahren nach Anspruch 7, **dadurch gekennzeichnet,daß** der basische Katalysator Pyridin ist.

9. Verfahren nach einem der Anspruche 7 bis 8, **dadurch gekennzeichnet, daß** als Wasser entziehendes Mittel Phosphoroxychlorid verwendet wird.

10. Verfahren nach einem der Ansprüche 7 bis 9, **dadurch gekennzeichnet, daß** die Behandlung mit einem Wasser entziehenden Mittel in Gegenwart von Anilin oder Phosphorpentasulfid durchgeführt wird.

11. Optische Vorrichtung, welche ein oder mehrere aromatische Poly(1,3,4-heterodiazole) nach einem der Ansprüche 1 bis 5 enthält.

12. Optische Vorrichtung nach Anspruch 11, **dadurch gekennzeichnet, daß** sie ein Elektrolumineszenz-Bauelement ist.

13. Verwendung von einem oder mehreren Poly(1,3,4-heterodiazolen) nach einem der Ansprüche 1 bis 5 bei der Herstellung einer Elektrolumineszenz- und/oder Elektronentransportschicht einer optischen Vorrichtung.

14. Verwendung nach Anspruch 13, **dadurch gekennzeichnet, daß** die Elektrolumineszenz- und/oder Elektronentransportschicht ein Mehrfachschichtsystem ist.

## Claims

1. Aromatic poly(1,3,4-heterodiazole) that is soluble in organic solvents, comprising 300 to 1000 recurrent units selected from the group consisting of 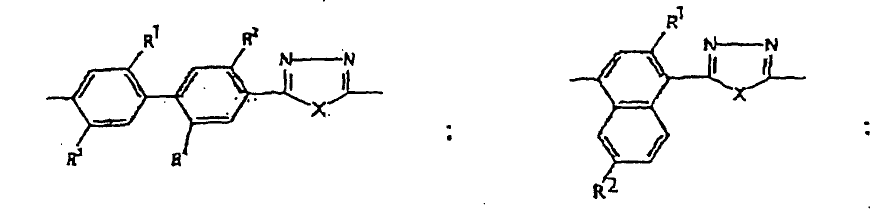 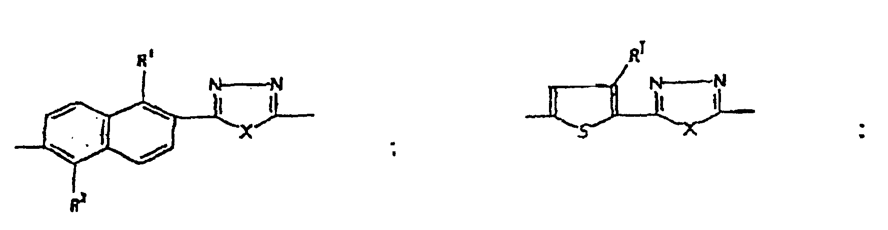 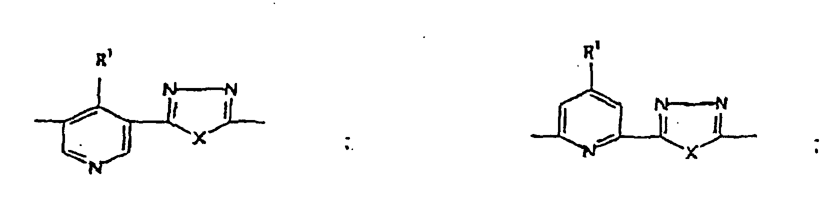 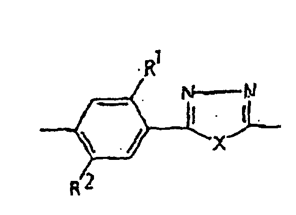 wherein R¹, R², R³ and R⁴ can be the same or different and respectively stand for an alkyl, alkoxy, phenyl, phenoxy or thiophenol grouping, and X stands for S, O or N-phenyl.

2. Aromatic poly(1,3,4-heterodiazole) according to Claim 1 with the general formula 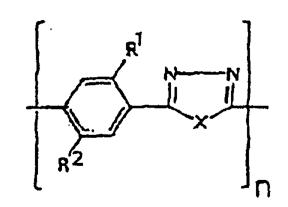 wherein R¹, R², R³, R⁴ and X are defined as in Claim 1 and n stands for a whole number from 300 to 1000.

3. Aromatic poly(1,3,4-heterodiazole) according to Claim 1 or 2, **characterised in that** R¹ and/or R² stand for the alkyl grouping, in which one or more non-adjacent CH₂ groups are substituted by -O- or -S-.

4. Aromatic poly(1,3,4-heterodiazole) according to Claims 1 to 3, **characterised in that** it comprises 300 to 700 recurrent units.

5. Aromatic poly(1,3,4-heterodiazole) according to Claim 1, **characterised in that** it is poly(2,5-di-phenyl{2',5'-di(2-ethyl-hexyloxy)}-1,3,4-oxadiazole), poly(2,5-di-phenyl{2',5'-di(2-ethyl-hexyloxy)}-1,3-phenyl-4-triazole) or poly(2,5-di-phenyl{2',5'-di(2-ethyl-hexyloxy)}-1,3,4-thiadiazole).

6. Process for the production of an aromatic poly(1,3,4-heterodiazole) according to Claim 1, **characterised in that** equimolar amounts of an acid dichloride or several acid dichlorides selected from the group consisting of 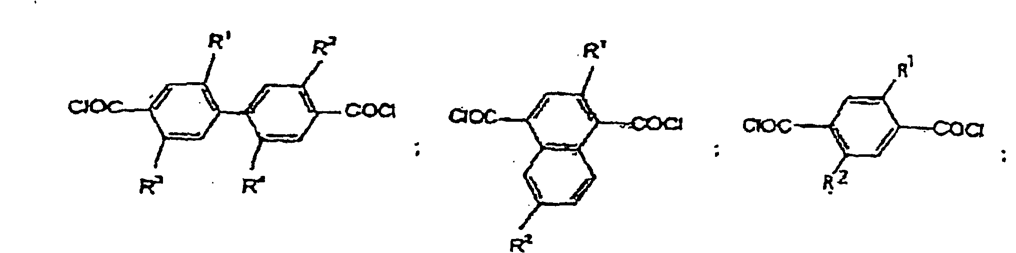 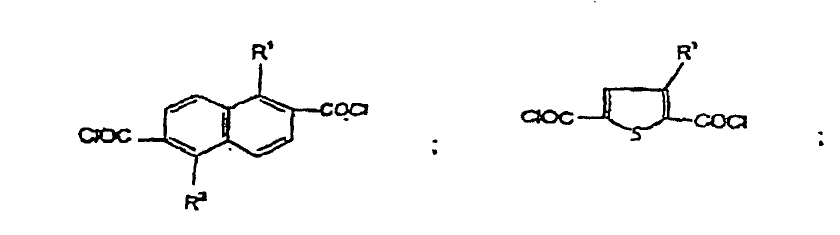 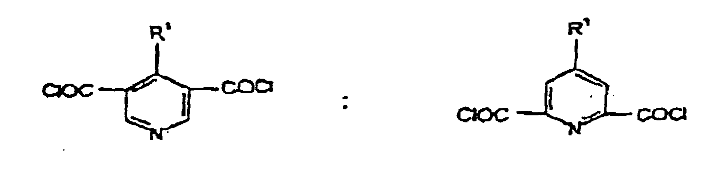 wherein R¹, R², R³ and R⁴ are defined as in Claim 1, and of a dicarboxylic acid hydrazide or several dicarboxylic acid hydrazides selected from the group consisting of 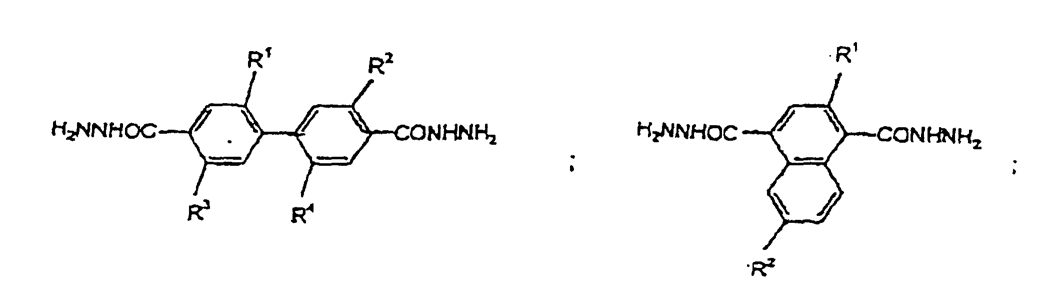 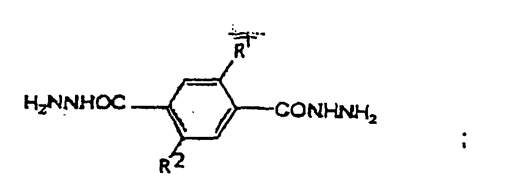 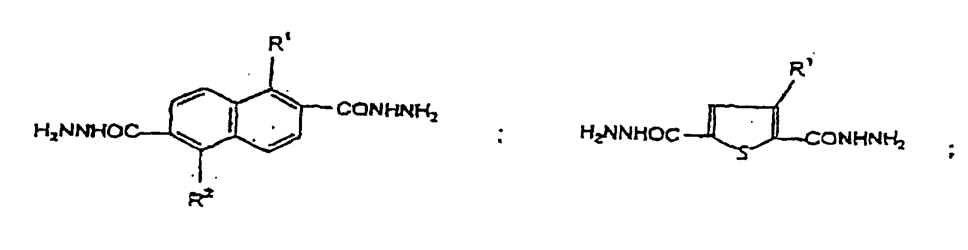 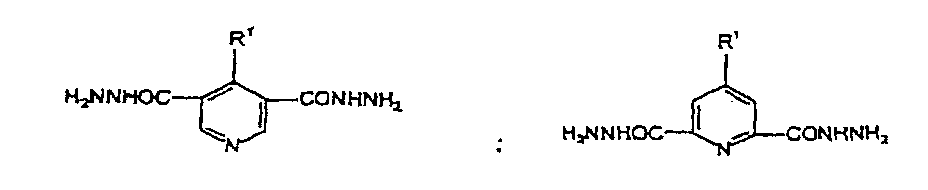 wherein R¹, R², R³ and R⁴ are defined as in Claim 1, are subjected to a condensation polymerisation process, the condensation product is separated, purified and then subjected to a ring closure reaction in the presence of a dehydrating agent, and the product is then separated and purified.

7. Process according to Claim 6, **characterised in that** the condensation polymerisation process is conducted in the presence of a base catalyst.

8. Process according to Claim 7, **characterised in that** the base catalyst is pyridine.

9. Process according to one of Claims 7 to 8, **characterised in that** phosphorus oxychloride is used as dehydrating agent.

10. Process according to one of Claims 7 to 9, **characterised in that** the treatment with a dehydrating agent is conducted in the presence of aniline or phosphorus pentasulphide.

11. Optical device, which contains one or more aromatic poly(1,3,4-heterodiazoles) according to one of Claims 1 to 5.

12. Optical device according to Claim 11, **characterised in that** it is an electroluminescent structural element.

13. Use of one or more poly(1,3,4-heterodiazoles) according to one of Claims 1 to 5 in the production of an electroluminescent and/or electron-transport layer of an optical device.

14. , Use according to Claim 13, **characterised in that** the electroluminescent and/or electron-transport layer is a multilayer system.

## Revendications

1. Poly(1,3,4-hétérodiazole) aromatique soluble dans les solvants organiques comprenant de 300 à 1000 éléments répétitifs choisis dans le groupe consistant en : 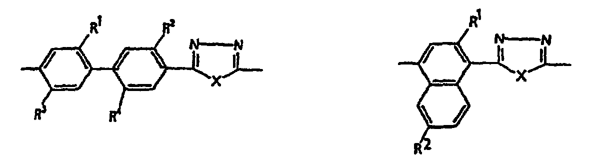 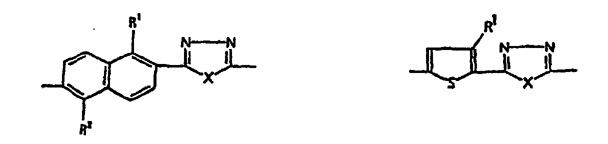 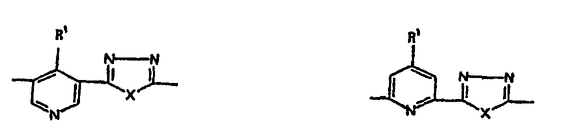 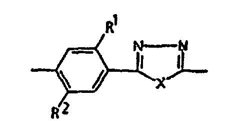 dans lesquels R¹, R², R³ et R⁴ peuvent être identiques ou différents et respectivement représentent un groupement alkyle, alkoxy, phényle, phénoxy ou thiophénol et X représente S, O ou N-phényle.

2. Poly(1,3,4-hétérodiazole) aromatique selon la revendication 1, de formule générale : 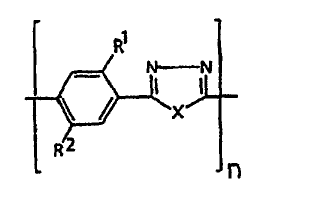 dans laquelle R¹, R², R³, R⁴ et sont définis comme à la revendication 1, et n représente un nombre entier allant de 300 à 1000.

3. Poly(1,3,4-hétérodiazole) aromatique selon l'une quelconque des revendications 1 ou 2,
**caractérisé en ce que**
R¹ et/ou R² représentent un groupement alkyle dans lequel un ou plusieurs groupes CH₂ non voisins sont remplacés par -O- ou par -S-.

4. Poly(1,3,4-hétérodiazole) aromatique selon l'une quelconque des revendications 1 à 3,
**caractérisé en ce qu'**
il comprend de 300 à 700 éléments répétitifs.

5. Poly(1,3,4-hétérodiazole) aromatique selon la revendication 1,
**caractérisé en ce qu'**
il est le poly(2,5-diphényl {2',5'-di(2-éthyl-hexyloxy)}-1,3,4-oxadiazole), le poly(2,5-di-phényl{2',5'-di(2-éthyl-hexyloxy)}-1,3-phényl-4-triazole) ou le poly(2,5-di-phényl{2',5'-di(2-éthyl-hexyloxy)}-1,3,4-thiadiazole).

6. Procédé de préparation d'un Poly(1,3,4-hétérodiazole) aromatique selon la revendication 1
**caractérisé en ce qu'**
on soumet des quantités équimolaies d'un dichlorure d'acide ou de plusieurs dichlorures d'acide choisis dans le groupe qui consiste en : 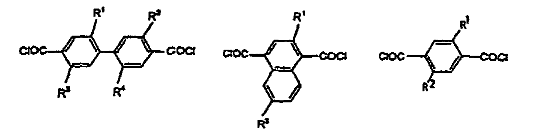 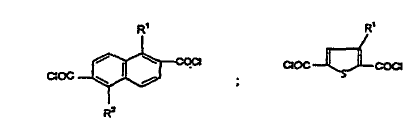 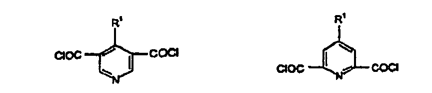 dans laquelle R¹, R², R³ et R⁴ sont définis comme à la revendication 1, et d'un hydrazide d'acide dicarboxylique ou de plusieurs hydrazides d'acide carboxylique choisis dans le groupe qui consiste en : 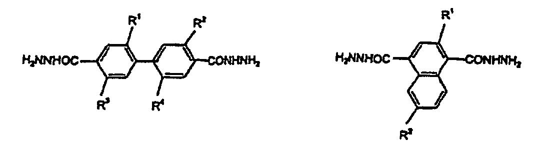 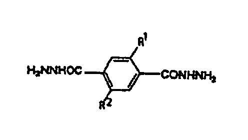 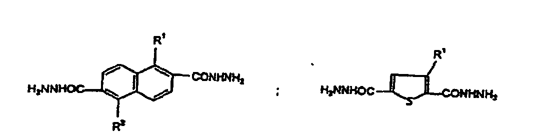 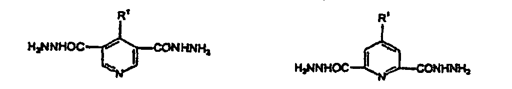 dans lesquels R¹, R², R³ et R⁴ sont définis comme à la revendication 1, à une polymérisation par condensation, on isole le produit de condensation, on le purifie et ensuite on le soumet à une réaction de cyclisation en présence d'un agent déshydratant et ensuite on isole le produit et le purifie.

7. Procédé selon la revendication 6,
**caractérisé en ce que**
la polymérisation par condensation est effectuée en présence d'un catalyseur basique.

8. Procédé selon la revendication 7,
**caractérisé en ce que**
le catalyseur basique est la pyridine.

9. Procédé selon l'une quelconque des revendications 7 à 8,
**caractérisé en ce que**
comme agent déshydratant on utilise de l'oxychlorure de phosphore.

10. Procédé selon l'une quelconque des revendications 7 à 9,
**caractérisé en ce que**
le traitement avec un agent déshydratant est effectué en présence d'aniline ou de pentasulfure de phosphore.

11. Dispositif optique qui renferme un ou plusieurs poly(1,3,4-hétérodiazoles) aromatique selon l'une quelconque des revendications 1 à 5.

12. Dispositif optique selon la revendication 11,
**caractérisé en ce qu'**
il est un composant électroluminescent.

13. Utilisation d'un ou plusieurs poly(1,3,4-hétérodiazoles) selon l'une quelconque des revendications 1 à 5, dans la production d'une couche d'électroluminescence et/ou de transport d'électrons d'un dispositif optique.

14. Utilisation selon la revendication 13,
**caractérisée en ce que**
la couche d'électroluminescence et/ou de transport d'électrons est un système multi-couches.
